# EUROPEAN PATENT APPLICATION

(11) **EP 4 651 200 A1**
(43) Date of publication of application: **19.11.2025**
(21) Application number: 25156422.5
(22) Date of filing: 07.02.2025
(51) Int. Cl.: H01L 23/00, H01L 23/544, H01L 25/065, H01L 21/768, H01L 23/522, H01L 23/528, H01L 23/532, H01L 23/538

(54) **SEMICONDUCTOR PACKAGE INCLUDING THROUGH ELECTRODE**

(30) Priority: 16.05.2024 KR 20240063828
(71) Applicant: SK hynix Inc., Bubal-eub Icheon-si Gyeonggi-do 17336 (KR)
(72) Inventor: KIM, Joo Hyun, 17336 Icheon-si, Gyeonggi-do (KR)
(74) Representative: Isarpatent

(57) **Abstract**

A semiconductor package includes a through electrode within a substrate. A wiring structure is disposed on the substrate and includes a chip pad and a protective insulating layer. A protrusion pattern is disposed on the protective insulating layer. A front bonding insulating layer is disposed on the wiring structure. The protrusion pattern is disposed within the front bonding insulating layer. A front bonding pad is disposed within the front bonding insulating layer and is connected to the chip pad.

## Description

### 1. TECHNICAL FIELD

The embodiments of the present disclosure relate to a semiconductor package including a through electrode and method of forming the same.

### 2. RELATED ART

A semiconductor chip formed on a semiconductor wafer is separated using a dicing process. The dicing process includes, for example, cutting a wafer along a center line of a scribe lane. In response to the demand for high integration of semiconductor packages, technology for stacking semiconductor chips is under development. The stacked semiconductor chips are electrically connected by through silicon vias (TSV) and bonding pads.

### SUMMARY

A semiconductor package according to an embodiment of the present disclosure may include a through electrode within a substrate. A wiring structure may be disposed on the substrate and may include a chip pad and a protective insulating layer. A protrusion pattern may be disposed on the protective insulating layer. A front bonding insulating layer may be disposed on the wiring structure. The protrusion pattern may be disposed within the front bonding insulating layer. A front bonding pad may be disposed within the front bonding insulating layer and may be connected to the chip pad.

A semiconductor package according to an embodiment of the present disclosure may include a first semiconductor chip and a second semiconductor chip bonded to the first semiconductor chip. The first semiconductor chip may include a first substrate, a first through electrode in the first substrate, a first wiring structure disposed on the first substrate and including a first chip pad and a first protective insulating layer, a first protrusion pattern on the first protective insulating layer, a first front bonding insulating layer on the first wiring structure, and a first front bonding pad disposed within the first front bonding insulating layer and connected to the first chip pad. The second semiconductor chip may include a second substrate, a second wiring structure disposed on the second substrate and including a second chip pad and a second protective insulating layer, a second protrusion pattern on the second protective insulating layer, a second front bonding insulating layer on the second wiring structure, and a second front bonding pad disposed within the second front bonding insulating layer and connected to the second chip pad. The first protrusion pattern may be disposed within the first front bonding insulating layer. The second protrusion pattern may be disposed within the second front bonding insulating layer.

A semiconductor package according to an embodiment of the present disclosure may include a wiring structure disposed on a substrate and including a chip pad and a protective insulating layer. A protrusion pattern may be disposed on the protective insulating layer. A front bonding insulating layer may be disposed on the wiring structure. The protrusion pattern may be disposed within the front bonding insulating layer. A front bonding pad may be disposed within the front bonding insulating layer and may be connected to the chip pad.

A method of forming a semiconductor package according to an embodiment of the present disclosure may include forming a substrate having a wiring structure. The method may include forming a groove penetrating the wiring structure. The method may include forming a front bonding insulating layer on the wiring structure after forming the groove. The method may include cutting the front bonding insulating layer and the substrate using a dicing process.

A semiconductor package according to an embodiment of the present disclosure may include a substrate; a wiring structure disposed on the substrate and including a protective insulating layer; an insulating layer disposed on a first surface and a second surface of the wiring structure, wherein the second surface extends away from the first surface; and a protrusion pattern disposed on the protective insulating layer and within the insulating layer, wherein the insulating layer is cut during a dicing process.

### BRIEF DESCRIPTION OF THE DRAWINGS

FIG. 1 is a cross-sectional view of a semiconductor package according to an embodiment of the present disclosure.
FIG. 2 to FIG. 6 are partial views illustrating a section of a semiconductor package according to an embodiment of the present disclosure.
FIG. 7 is a cross-sectional view of a semiconductor package according to an embodiment of the present disclosure.
FIG.8 is a flowchart illustrating a method of forming a semiconductor package according to an embodiment of the present disclosure.
FIG. 9 is a plan view of a substrate including semiconductor chips according to an embodiment of the present disclosure.
FIG. 10 is a partial view illustrating a section of a substrate including semiconductor chips according to an embodiment of the present disclosure.
FIG. 11 to FIG. 26 are cross-sectional views of a of a semiconductor package formed utilizing a method according to an embodiment of the present disclosure.

### DETAILED DESCRIPTION

Embodiments of the present disclosure are described detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

The cross-hatching throughout the figures illustrates corresponding or similar areas between the figures rather than indicating the materials associated with the areas. Terms such as "vertical," "horizontal," "top," "bottom," "over," "on," "side," "inside," "upper," "uppermost," "lower," "higher," "front," "back," "column," "row," "level," and other terms implying relative spatial relationship or orientation are utilized only for the purpose of ease of description or reference to a drawing and are not otherwise limiting.

When one element is identified as "connected" to another element, the elements may be connected directly or through at least one intervening element between the elements. When two elements are identified as "directly connected," one element is directly connected to the other element without an intervening element between the two elements.

When time relative terms such as "after," "before," and the like are used to describe a relationship between two processes, the two processes or operations may be non-consecutive or non-sequential processes or operations, with or without intervening processes between the two processes or operations. When time relative terms are used in conjunction with "directly" or "immediately" for two processes, the two processes are performed consecutively or sequentially.

An embodiment of the present disclosure includes a semiconductor package with a through electrode and method of forming the same.

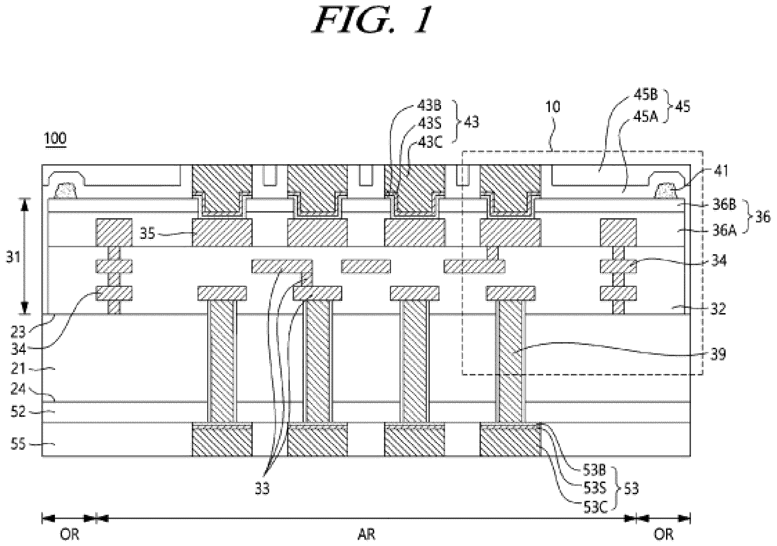

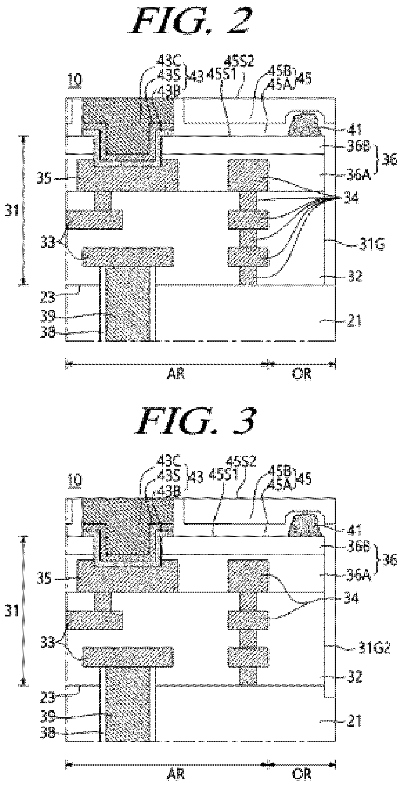

FIG. 1 is a cross-sectional view of a semiconductor package according to an embodiment of the present disclosure. FIG. 2 to FIG. 6 are partial views illustrating a section 10, for example, as shown in the dashed box in FIG. 1.

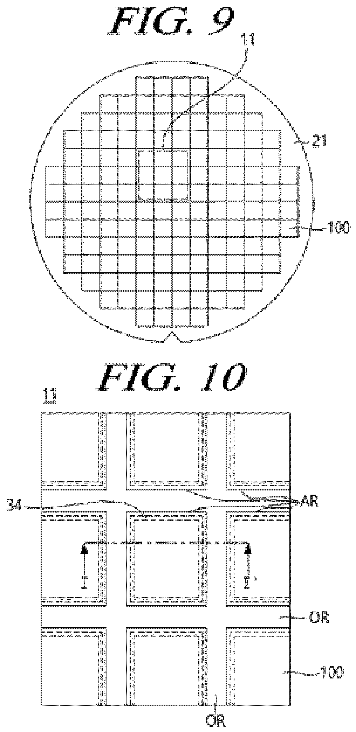

Referring to FIG. 1, a semiconductor package according to an embodiment of the present disclosure includes a semiconductor chip 100. The semiconductor chip 100 includes a substrate 21, a wiring structure 31, a through electrode 39, a protrusion pattern 41, a front bonding pad 43, a front bonding insulating layer 45, a back insulating layer 52, a back bonding pad 53, and a back bonding insulating layer 55. The semiconductor chip 100 includes an active area AR and an outer area OR. The outer area OR is continuous along an outer perimeter of the active area AR. The wiring structure 31 includes a guard ring 34 that serves as an indicator that separates the active area AR and the outer area OR. The guard ring 34, the active area AR, and the outer area OR are described with reference to FIG. 9 and FIG. 10.

The substrate 21 includes a first surface 23 opposing a second surface 24. The first surface 23 is referred to as a front side of the substrate 21, and the second surface 24 is referred to as a back side of the substrate 21. The substrate 21 extends across the active area AR and the outer area OR. The wiring structure 31 includes a circuit insulating layer 32, a horizontal/vertical wiring 33, a guard ring 34, a chip pad 35, and a protective insulating layer 36. The semiconductor chip 100 may include various types of active/passive elements such as transistors and/or capacitors inside the substrate 21, extending between the substrate 21 and the wiring structure 31, and/or inside the wiring structure 31. In an embodiment, the semiconductor chip 100 includes memory, a processor, or a combination thereof. The semiconductor chip 100 may include dynamic random access memory (DRAM), static random access memory (SRAM), flash memory, magnetoresistive random access memory (MRAM), phase-change random access memory (PRAM), ferroelectric random access memory (FRAM), resistive random access memory (RRAM), or a combination thereof.

The wiring structure 31 is disposed on the first surface 23 of the substrate 21. In an embodiment, a horizontal width of the wiring structure 31 is smaller than a horizontal width of the substrate 21. The through electrodes 39 penetrate the substrate 21 in a vertical direction. The through electrodes 39 are connected to the wiring structure 31. In an embodiment, one end of the through electrode 39 penetrates the circuit insulating layer 32 and contacts the horizontal/vertical wiring 33.

The front bonding insulating layer 45 is disposed on the wiring structure 31. A front bonding pad 43 is disposed within the front bonding insulating layer 45. The top surface of the front bonding insulating layer 45 and the top surface of the front bonding pad 43 are formed in substantially the same plane. The front bonding pad 43 contacts the chip pad 35 within the wiring structure 31. The front bonding pad 43 is electrically connected to the horizontal/vertical wiring 33 through the chip pad 35.

A protrusion pattern 41 is disposed on the protective insulating layer 36 of the wiring structure 31. The protrusion pattern 41 is covered, disposed, or buried within the front bonding insulating layer 45. The protrusion pattern 41 is disposed near an edge of the wiring structure 31 or is in disposed at the edge of the wiring structure 31. The protrusion pattern 41 is disposed within the outer area OR. In an embodiment, a distance between the edge of the wiring structure 31 and the protrusion pattern 41 is smaller than a distance between the edge of the wiring structure 31 and the chip pad 35. The distance between the edge of the wiring structure 31 and the protrusion pattern 41 is smaller than a distance between the edge of the wiring structure 31 and the front bonding pad 43.

The front bonding insulating layer 45 extend downward along sides of the wiring structure 31. In an embodiment, the front bonding insulating layer 45 completely surrounds or covers the sides of the wiring structure 31. One end of the front bonding insulating layer 45 is disposed near or adjacent to a boundary between the substrate 21 and the wiring structure 31. In an embodiment, one end of the front bonding insulating layer 45 contacts the surfaces at the boundary or interface between the substrate 21 and the wiring structure 31.

A back insulating layer 52 and a back bonding insulating layer 55 are sequentially disposed on the second surface 24 of the substrate 21. The back bonding pad 53 contacts the back insulating layer 52. The back bonding pad 53 is disposed within the back bonding insulating layer 55. A lower surface of the back bonding insulating layer 55 and the back bonding pad 53 are formed in substantially the same plane in the example of FIG. 1. One end of the through electrode 39 penetrates the back insulating layer 52 and contacts the back bonding pad 53.

In an embodiment, the sides of the back bonding insulating layer 55, the back insulating layer 52, the substrate 21, and the front bonding insulating layer 45 are vertically aligned. Side surfaces of the back bonding insulating layer 55, the back insulating layer 52, the substrate 21, and the front bonding insulating layer 45 are formed in substantially the same plane. In the example where the side surface of the wiring structure 31 is completely covered by the front bonding insulating layer 45, the side surface of the wiring structure 31 is not exposed. Each of the back bonding insulating layer 55, the back insulating layer 52, the substrate 21, and the front bonding insulating layer 45 have substantially the same horizontal width.

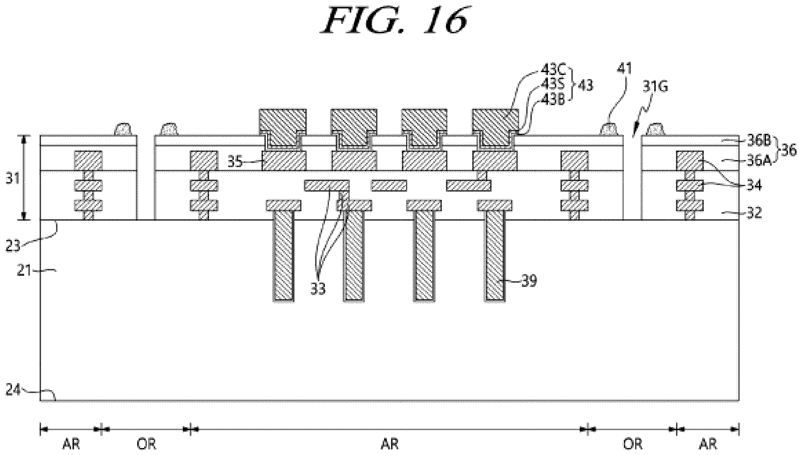

Referring to FIG. 2, the protrusion pattern 41 is disposed on the protective insulating layer 36. In an embodiment, the protrusion pattern 41 is disposed within the outer area OR. The protrusion pattern 41 is not exposed to the environment outside the semiconductor package due to the front bonding insulating layer 45. The protrusion pattern 41 is completely covered, disposed, or buried within the front bonding insulating layer 45 in this example. The front bonding insulating layer 45 includes a first surface 45S1 and a second surface 45S2 facing opposite directions. The first surface 45S1 of the front bonding insulating layer 45 is in contact with the wiring structure 31. The second surface 45S2 of the front bonding insulating layer 45 may be relatively distant from the wiring structure 31. In an embodiment, the protrusion pattern 41 is formed between the wiring structure 31 and the second surface 45S2 of the front bonding insulating layer 45. The protrusion pattern 41 is disposed, located or confined between the wiring structure 31 and the second surface 45S2 of the front bonding insulating layer 45. The protrusion pattern 41 may include a material different than the material of the front bonding insulating layer 45. The material composition of the protrusion pattern 41 is described with reference to FIG. 16.

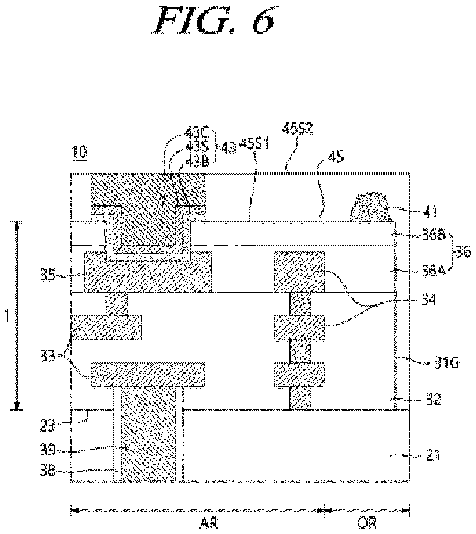

A groove 31G penetrating the wiring structure 31 is disposed within the outer area OR. The groove 31G is described in detail with reference to FIG. 16. The front bonding insulating layer 45 extends inside or fills the groove 31G. The front bonding insulating layer 45 contacts the side surface of the wiring structure 31. The bottom of the front bonding insulating layer 45 may contact the substrate 21. In an embodiment, a boundary between the front bonding insulating layer 45 and the substrate 21 are in substantially the same plane as a boundary between the wiring structure 31 and the substrate 21, such as shown in FIG. 2 and FIG. 6. The sides of the substrate 21 and the front bonding insulating layer 45 are vertically aligned as shown in the examples in FIG. 1 through FIG. 6. Side surfaces of the substrate 21 and the front bonding insulating layer 45 are formed in substantially the same plane.

The front bonding insulating layer 45 includes a single layer or two or more layers of material. The front bonding insulating layer 45 may include at least two or more materials selected from the group consisting of silicon (Si), oxygen (O), nitrogen (N), carbon (C), and boron (B). The front bonding insulating layer 45 may include silicon oxide, silicon nitride, silicon oxynitride, silicon carbonitride (SiCN), silicon oxycarbonitride (SiOCN), a low-k dielectric, a high-k dielectric, or a combination thereof.

An upper surface or a top of the front bonding pad 43 is formed in substantially the same plane as the second surface 45S2 of the front bonding insulating layer 45. In an embodiment, the front bonding insulating layer 45 includes a first or lower bonding insulating layer 45A and a second or upper bonding insulating layer 45B. The lower bonding insulating layer 45A is disposed on the protective insulating layer 36 and the protrusion pattern 41. The lower bonding insulating layer 45A covers an upper surface and side surfaces of the protrusion pattern 41 in this example.

The lower bonding insulating layer 45A surrounds the side surfaces of the front bonding pad 43. The lower bonding insulating layer 45A contacts an upper surface of the protective insulating layer 36. The lower bonding insulating layer 45A completely covers an upper surface and a side surface of the protrusion pattern 41 in this example. The lower bonding insulating layer 45A extends inside the groove 31G. The lower bonding insulating layer 45A contacts the side of the protective insulating layer 36, the side of the circuit insulating layer 32, and the substrate 21. The lower bonding insulating layer 45A prevents the materials of the front bonding pad 43, for example, a conductive material such as copper, from spreading or diffusing. The upper surface of the lower bonding insulating layer 45A may include an uneven structure. The upper bonding insulating layer 45B is disposed on the lower bonding insulating layer 45A. The lower bonding insulating layer 45A extends between the upper bonding insulating layer 45B and the front bonding pad 43. The top of the front bonding pad 43, the top of the lower bonding insulating layer 45A, and the top of the upper bonding insulating layer 45B are formed in substantially the same plane.

The upper bonding insulating layer 45B includes a material having a better gap-fill property and insulating property than the lower bonding insulating layer 45A. The lower bonding insulating layer 45A may include nitride, such as silicon nitride. The upper bonding insulating layer 45B may include silicon oxide (for example, thermal oxide, or silicon oxide formed by plasma enhanced chemical vapor deposition (PECVD) using tetra ethyl ortho silicate (TEOS), and so forth), silicon nitride, silicon oxynitride, silicon carbonitride (SiCN), silicon oxycarbonitride (SiOCN), or a combination thereof. In an embodiment, the upper bonding insulating layer 45B includes silicon oxide or silicon carbonitride (SiCN).

A through electrode 39 vertically penetrates the substrate 21 and the circuit insulating layer 32 and contacts the horizontal/vertical wiring 33. A spacer 38 is formed on the side of the through electrode 39. The spacer 38 surrounds the sides of the through electrode 39. The through electrode 39 is insulated from the substrate 21 by the spacer 38.

The chip pad 35 is disposed on the circuit insulating layer 32. The chip pad 35 is electrically connected to the horizontal/vertical wiring 33. The protective insulating layer 36 covers or is disposed on the circuit insulating layer 32 and covers or is disposed on an edge or outer perimeter of the chip pad 35.

The protective insulating layer 36 includes a single layer or two or more layers of material. The protective insulating layer 36 may include at least two materials selected from the group consisting of silicon (Si), oxygen (O), nitrogen (N), carbon (C), and boron (B). Each of the circuit insulating layer 32, the protective insulating layer 36, and the spacer 38 may include silicon oxide, silicon nitride, silicon oxynitride, silicon carbonitride (SiCN), silicon oxycarbonitride (SiOCN), a low-k dielectric material, a high-K dielectric material, or a combination thereof.

In an embodiment, the protective insulating layer 36 may include a lower protective insulating layer 36A and an upper protective insulating layer 36B. The upper protective insulating layer 36B is formed on the lower protective insulating layer 36A. The lower protective insulating layer 36A may include a material having better gap-fill property and insulating property than the upper protective insulating layer 36B. The lower protective insulating layer 36A may include silicon oxide formed using TEOS (Tetra Ethyl Ortho Silicate). The upper protective insulating layer 36B may include a material having better moisture resistance compared to the lower protective insulating layer 36A. The upper protective insulating layer 36B may include a material capable of compensating for the stress caused by the lower protective insulating layer 36A. The upper protective insulating layer 36B may include silicon nitride.

The front bonding pad 43 is disposed on the protective insulating layer 36. The front bonding pad 43 penetrates the protective insulating layer 36 and contacts the chip pad 35. During performance of patterning the protective insulating layer 36, the top surface of the chip pad 35 is partially recessed by over-etching. The center area of the top surface of the chip pad 35 is recessed at a lower level than the outer perimeter. The bottom of the front bonding pad 43 may extend to a level lower than the top of the chip pad 35. A thickness of the chip pad 35 in the contact area between the chip pad 35 and the front bonding pad 43 is smaller or thinner than a thickness of the chip pad 35 in the overlapping area between the chip pad 35 and the protective insulating layer 36. Thus, a thickness of the chip pad 35 in the contact area between the chip pad 35 and the front bonding pad 43 is smaller than the thickness of the chip pad 35 at an outermost perimeter of the chip pad 35. In an embodiment, the front bonding pad 43 includes a first barrier layer 43B, a first seed layer 43S, and a first conductive layer 43C.

Referring to FIG. 3, the groove 31G2 completely penetrates the wiring structure 31 in the vertical direction and extends into the substrate 21. The lower end of the front bonding insulating layer 45 extends into the substrate 21. The boundary between the bottom of the front bonding insulating layer 45 and the substrate 21 is disposed at a lower level than the boundary between the wiring structure 31 and the substrate 21.

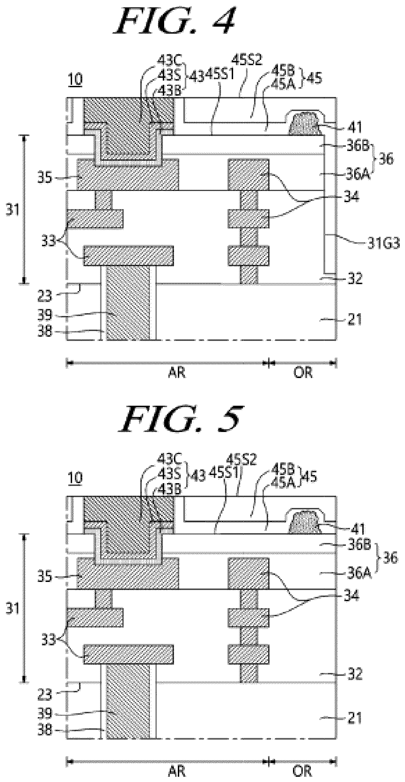

Referring to FIG. 4, the groove 31G3 is formed and ends within the wiring structure 31. A section of the circuit insulating layer 32 remains between the bottom of the groove 31G3 and the substrate 21. The bottom of the front bonding insulating layer 45 is disposed at a level higher than the boundary between the wiring structure 31 and the substrate 21. The circuit insulating layer 32 of the wiring structure 31 extends between the bottom of the front bonding insulating layer 45 and the first surface 23 of the substrate 21. The sides of the substrate 21, the circuit insulating layer 32, and the front bonding insulating layer 45 are vertically aligned in this example. Side surfaces of the substrate 21, the circuit insulating layer 32, and the front bonding insulating layer 45 are formed in substantially the same plane.

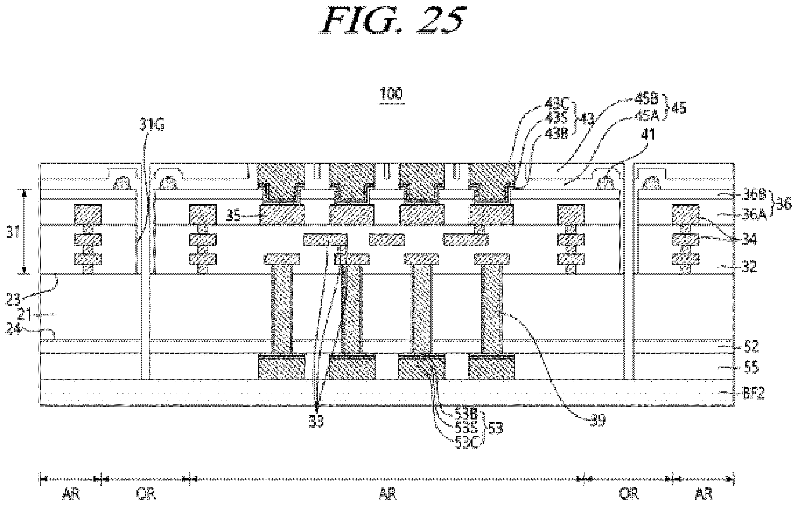

Referring to FIG. 5, the side surfaces of the substrate 21, the circuit insulating layer 32, the protective insulating layer 36, and the front bonding insulating layer 45 are vertically aligned. Side surfaces of the substrate 21, the circuit insulating layer 32, the protective insulating layer 36, and the front bonding insulating layer 45 are formed in substantially the same plane. Exposure of the side surfaces of the substrate 21, the circuit insulating layer 32, the protective insulating layer 36, and the front bonding insulating layer 45 are described with reference to FIG. 25.

Referring to FIG. 6, the front bonding insulating layer 45 may include a single layer. The protrusion pattern 41 may be completely covered, disposed, or buried within the front bonding insulating layer 45. The upper surface of the front bonding pad 43 and the second surface 45S2 of the front bonding insulating layer 45 are formed in substantially the same plane.

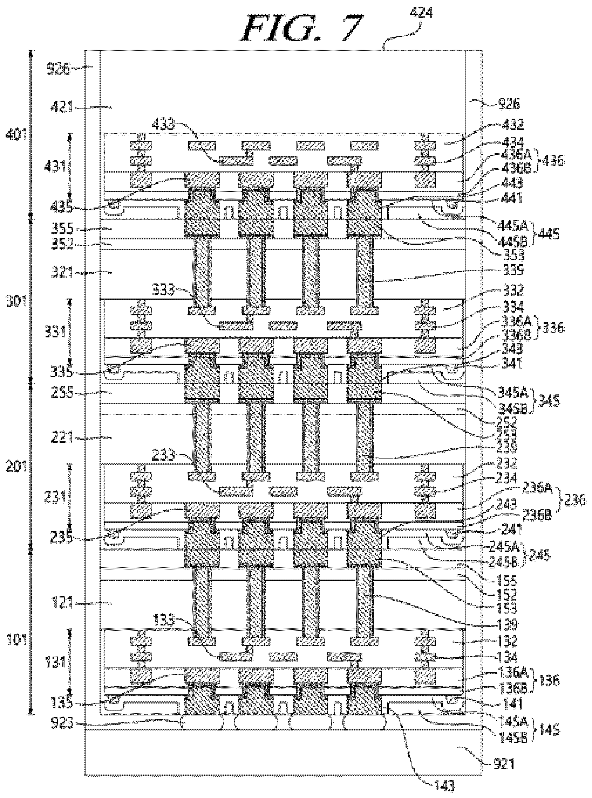

FIG. 7 is a cross-sectional view of a semiconductor package according to an embodiment of the present disclosure. In an embodiment, a semiconductor package includes a stacked package or a multi-chip package.

Referring to FIG. 7, a semiconductor package according to an embodiment of the present disclosure includes a first semiconductor chip 101, a second semiconductor chip 201, a third semiconductor chip 301, and a fourth semiconductor chip 401 sequentially stacked on a base structure 921. Each of the semiconductor chips 101, 201, 301, and 401 may have a similar configuration such as described with reference to FIG. 1, for example. A connection terminals 923 are disposed between the first semiconductor chip 101 and the base structure 921. An encapsulation layer 926 covering the semiconductor chips 101, 201, 301, and 401 is disposed on the base structure 921.

The first semiconductor chip 101 includes a first substrate 121, a first wiring structure 131, a first through electrode 139, a first protrusion pattern 141, a first front bonding pad 143, a first front bonding insulating layer 145, a first back insulating layer 152, a first back bonding pad 153, and a first back bonding insulating layer 155. The first substrate 121, the first wiring structure 131, the first through electrode 139, the first protrusion pattern 141, the first front bonding pad 143, the first front bonding insulating layer 145, the first back insulating layer 152, the first back bonding pad 153, and the first back bonding insulating layer 155 may have similar configurations as the substrate 21, the wiring structure 31, the through electrode 39, the protrusion pattern 41, the front bonding pad 43, the front bonding insulating layer 45, the back insulating layer 52, the back bonding pad 53, and the back bonding insulating layer 55, respectively, such as described with reference to FIG. 1 to FIG. 6.

The first wiring structure 131 includes a first circuit insulating layer 132, a first horizontal/vertical wiring 133, a first guard ring 134, a first chip pad 135, and a first protective insulating layer 136. The first circuit insulating layer 132, the first horizontal/vertical wiring 133, the first guard ring 134, the first chip pad 135, and the first protective insulating layer 136 may have similar configurations as the circuit insulating layer 32, the horizontal/vertical wiring 33, the guard ring 34, the chip pad 35, and the protective insulating layer 36, respectively, such as described with reference to FIG. 1 to FIG. 6.

The first protective insulating layer 136 includes a first lower protective insulating layer 136A and a first upper protective insulating layer 136B. The first lower protective insulating layer 136A and the first upper protective insulating layer 136B may have similar configurations as the lower protective insulating layer 36A and the upper protective insulating layer 36B, respectively, such as described with reference to FIG. 1 to FIG. 6. The first front bonding insulating layer 145 includes a first lower bonding insulating layer 145A and a first upper bonding insulating layer 145B. The first lower bonding insulating layer 145A and the first upper bonding insulating layer 145B may have similar configurations as the lower bonding insulating layer 45A and the upper bonding insulating layer 45B, respectively, such as described with reference to FIG. 1 to FIG. 6.

The second semiconductor chip 201 includes a second substrate 221, a second wiring structure 231, a second through electrode 239, a second protrusion pattern 241, a second front bonding pad 243, a second front bonding insulating layer 245, a second back insulating layer 252, a second back bonding pad 253, and a second back bonding insulating layer 255. The second substrate 221, the second wiring structure 231, the second through electrode 239, the second protrusion pattern 241, the second front bonding pad 243, the second front bonding insulating layer 245, the second back insulating layer 252, the second back bonding pad 253, and the second back bonding insulating layer 255 may have similar configurations as the substrate 21, the wiring structure 31, the through electrode 39 layer Same as the electrode 39, the protrusion pattern 41, the front bonding pad 43, the front bonding insulating layer 45, the back insulating layer 52, the back bonding pad 53, and the back bonding insulating layer 55, respectively, as described with reference to FIG. 1 to FIG. 6.

The second wiring structure 231 includes a second circuit insulating layer 232, a second horizontal/vertical wiring 233, a second guard ring 234, a second chip pad 235, and a second protective insulating layer 236. The second circuit insulating layer 232, the second horizontal/vertical wiring 233, the second guard ring 234, the second chip pad 235, and the second protective insulating layer 236 may have similar configurations as the circuit insulating layer 32, the horizontal/vertical wiring 33, the guard ring 34, the chip pad 35, and the protective insulating layer 36, respectively, such as described with reference to FIG. 1 to FIG. 6.

The second protective insulating layer 236 includes a second lower protective insulating layer 236A and a second upper protective insulating layer 236B. The second lower protective insulating layer 236A and the second upper protective insulating layer 236B may have similar configurations as the lower protective insulating layer 36A and the upper protective insulating layer 36B, respectively, such as described with reference to FIG. 1 to FIG. 6. The second front bonding insulating layer 245 includes a second lower bonding insulating layer 245A and a second upper bonding insulating layer 245B. The second lower bonding insulating layer 245A and the second upper bonding insulating layer 245B may have similar configurations as the lower bonding insulating layer 45A and the upper bonding insulating layer 45B, respectively, such as described with reference to FIG. 1 to FIG. 6.

The third semiconductor chip 301 includes a third substrate 321, a third wiring structure 331, a third through electrode 339, a third protrusion pattern 341, a third front bonding pad 343, a third front bonding insulating layer 345, a third back insulating layer 352, a third back bonding pad 353, and a third back bonding insulating layer 355. The third substrate 321, the third wiring structure 331, the third through electrode 339, the third protrusion pattern 341, the third front bonding pad 343, the third front bonding insulating layer 345, the third back insulating layer 352, the third back bonding pad 353, and the third back bonding insulating layer 355 may have similar configurations as the substrate 21, the wiring structure 31, the through electrode 39, the protrusion pattern 41, the front bonding pad 43, the front bonding insulating layer 45, the back insulating layer 52, the back bonding pad 53, and the back bonding insulating layer 55, respectively, such as described with reference to FIG. 1 to FIG. 6.

The third wiring structure 331 includes a third circuit insulating layer 332, a third horizontal/vertical wiring 333, a third guard ring 334, a third chip pad 335, and a third protective insulating layer 336. The third circuit insulating layer 332, the third horizontal/vertical wiring 333, the third guard ring 334, the third chip pad 335, and the third protective insulating layer 336 may have similar configurations as the circuit insulating layer 32, the horizontal/vertical wiring 33, the guard ring 34, the chip pad 35, and the protective insulating layer 36, respectively, such as described with reference to FIG. 1 to FIG. 6.

The third protective insulating layer 336 includes a third lower protective insulating layer 336A and a third upper protective insulating layer 336B. The third lower protective insulating layer 336A and the third upper protective insulating layer 336B may have similar configurations as the lower protective insulating layer 36A and the upper protective insulating layer 36B, respectively, such as described with reference to FIG. 1 to FIG. 6. The third front bonding insulating layer 345 includes a third lower bonding insulating layer 345A and a third upper bonding insulating layer 345B. The third lower bonding insulating layer 345A and the third upper bonding insulating layer 345B may have similar configurations as the lower bonding insulating layer 45A and the upper bonding insulating layer 45B, respectively, such as described with reference to FIG. 1 to FIG. 6.

The uppermost semiconductor chip or the fourth semiconductor chip 401 may have a similar configuration in which some components (for example, the through electrode 39, the back insulating layer 52, and the back bonding pad 53 and the back bonding insulating layer 55) of the semiconductor chip 100 shown in FIG. 1 are not included. In an embodiment, a thickness of the uppermost/fourth semiconductor chip 401 is greater than a thickness of each of the semiconductor chips 101, 201, and 301. In an embodiment, the uppermost/fourth semiconductor chip 401 may have a similar configuration as the semiconductor chip 100 shown in FIG. 1. The thickness of the uppermost/fourth semiconductor chip 401 may be substantially the same as a thickness of each of the semiconductor chips 101, 201, and 301.

The fourth semiconductor chip 401 includes a fourth substrate 421, a fourth wiring structure 431, a fourth protrusion pattern 441, a fourth front bonding pad 443, and a fourth front bonding insulating layer 445. The fourth substrate 421, the fourth wiring structure 431, the fourth protrusion pattern 441, the fourth front bonding pad 443, and the fourth front bonding insulating layer 445 may have similar configuration as the substrate 21, the wiring structure 31, the protrusion pattern 41, the front bonding pad 43, and the front bonding insulating layer 45, respectively, such as described with reference to FIG. 1 to FIG. 6.

The fourth wiring structure 431 includes a fourth circuit insulating layer 432, a fourth horizontal/vertical wiring 433, a fourth guard ring 434, a fourth chip pad 435, and a fourth protective insulating layer 436. The fourth circuit insulating layer 432, the fourth horizontal/vertical wiring 433, the fourth guard ring 434, the fourth chip pad 435, and the fourth protective insulating layer 436 may have similar configuration as the circuit insulating layer 32, the horizontal/vertical wiring 33, the guard ring 34, the chip pad 35, and the protective insulating layer 36, respectively, such as described with reference to FIG. 1 to FIG. 6.

The fourth protective insulating layer 436 includes a fourth lower protective insulating layer 436A and a fourth upper protective insulating layer 436B. The fourth lower protective insulating layer 436A and the fourth upper protective insulating layer 436B may have similar configurations as the lower protective insulating layer 36A and the upper protective insulating layer 36B, respectively, such as described with reference to FIG. 1 to FIG. 6. The fourth front bonding insulating layer 445 includes a fourth lower bonding insulating layer 445A and a fourth upper bonding insulating layer 445B. The fourth lower bonding insulating layer 445A and the fourth upper bonding insulating layer 445B may have similar configurations as the lower bonding insulating layer 45A and the upper bonding insulating layer 45B, respectively, such as described with reference to FIG. 1 to FIG. 6.

The base structure 921 includes any substrate used in the semiconductor field. In an embodiment, the base structure 921 includes a base chip, an interposer, or a combination thereof. The connection terminals 923 are formed between the first front bonding pads 143 of the first semiconductor chip 101 and the base structure 921. The first semiconductor chip 101 is electrically connected to the base structure 921 through the first front bonding pad 143. The connection terminal 923 may include a conductive bump, a solder ball, a conductive pin, or a combination thereof.

The second semiconductor chip 201 is bonded to the first semiconductor chip 101. The second front bonding insulating layer 245 of the second semiconductor chip 201 is bonded to the first back bonding insulating layer 155 of the first semiconductor chip 101. The second front bonding pad 243 is bonded to the first back bonding pad 153 of the first semiconductor chip 101. The second protrusion pattern 241 of the second semiconductor chip 201 may be covered, disposed, or buried within the second front bonding insulating layer 245. In an embodiment, the second front bonding insulating layer 245 of the second semiconductor chip 201 directly contacts the first back bonding insulating layer 155 of the first semiconductor chip 101. The second front bonding pad 243 of the second semiconductor chip 201 directly contacts the first back bonding pad 153 of the first semiconductor chip 101 in an embodiment.

In an embodiment, because the second protrusion pattern 241 is covered, disposed, or buried within the second front bonding insulating layer 245, an interface between the second front bonding insulating layer 245 and the first back bonding insulating layer 155 is maintained as flat. Accordingly, the bonding force may be strengthened between the second front bonding insulating layer 245 and the first back bonding insulating layer 155. Because the interface between the second front bonding insulating layer 245 and the first back bonding insulating layer 155 is maintained as flat, joint defects such as peeling, lifting, non-bonding, or voids between the first semiconductor chip 101 and the second semiconductor chip 201 may be prevented.

The third semiconductor chip 301 is bonded to the second semiconductor chip 201 in a similar manner as the first semiconductor chip 101 is bonded to the second semiconductor chip 201. The third front bonding insulating layer 345 of the third semiconductor chip 301 is bonded to the second back bonding insulating layer 255 of the second semiconductor chip 201. The third front bonding pad 343 is bonded to the second back bonding pad 253 of the second semiconductor chip 201. The third protrusion pattern 341 of the third semiconductor chip 301 is be covered, disposed, or buried within the third front bonding insulating layer 345. In an embodiment, the third front bonding insulating layer 345 of the third semiconductor chip 301 directly contacts the second back bonding insulating layer 255 of the second semiconductor chip 201. The third front bonding pad 343 of the third semiconductor chip 301 directly contacts the second back bonding pad 253 of the second semiconductor chip 201 in an embodiment.

In an embodiment, because the third protrusion pattern 341 is covered, disposed, or buried within the third front bonding insulating layer 345, an interface between the third front bonding insulating layer 345 and the second back bonding insulating layer 255 is maintained as flat. Accordingly, the bonding force may be strengthened between the third front bonding insulating layer 345 and the second back bonding insulating layer 255. Because the interface between the third front bonding insulating layer 345 and the second back bonding insulating layer 255 is maintained as flat, joint defects such as peeling, lifting, non-bonding, or voids between the second semiconductor chip 201 and the third semiconductor chip 301 may be prevented.

The fourth semiconductor chip 401 is bonded to the third semiconductor chip 301 in a similar manner as the second semiconductor chip 201 is bonded to the third semiconductor chip 301. The fourth front bonding insulating layer 445 of the fourth semiconductor chip 401 is bonded to the third back bonding insulating layer 355 of the third semiconductor chip 301. The fourth front bonding pad 443 is bonded to the third back bonding pad 353 of the third semiconductor chip 301. The fourth protrusion pattern 441 of the fourth semiconductor chip 401 is covered, disposed, or buried within the fourth front bonding insulating layer 445. In an embodiment, the fourth front bonding insulating layer 445 of the fourth semiconductor chip 401 directly contacts the third back bonding insulating layer 355 of the third semiconductor chip 301. The fourth front bonding pad 443 of the fourth semiconductor chip 401 directly contacts the third back bonding pad 353 of the third semiconductor chip 301 in an embodiment. One or more additional semiconductor chips may be bonded between the third semiconductor chip 301 and the uppermost semiconductor chip, the fourth semiconductor chip 401 in this example.

In an embodiment, because the fourth protrusion pattern 441 is covered, disposed, or buried in the fourth front bonding insulating layer 445, an interface between the fourth front bonding insulating layer 445 and the third back bonding insulating layer 355 is maintained as flat. Accordingly, the bonding force may be strengthened between the fourth front bonding insulating layer 445 and the third back bonding insulating layer 355. Because the interface between the fourth front bonding insulating layer 445 and the third back bonding insulating layer 355 is maintained as flat, joint defects such as peeling, lifting, non-bonding, or voids between the third semiconductor chip 301 and the fourth semiconductor chip 401 may be prevented.

The encapsulation layer 926 includes an epoxy molding compound. The encapsulation layer 926 covers the side surfaces of the semiconductor chips 101, 201, 301, and 401 and extends between the first semiconductor chip 101 and the base structure 921. The connection terminal 923 penetrates the encapsulation layer 926 and contacts the first semiconductor chip 101 and the base structure 921. The second surface 424 of the uppermost/fourth semiconductor chip 401 is formed in substantially the same plane as the upper surface of the encapsulation layer 926. In an embodiment, the second surface 424 of the uppermost / fourth semiconductor chip 401) is exposed. In an embodiment, the encapsulation layer 926 may be formed to cover the second surface 424 of the uppermost/fourth semiconductor chip 401.

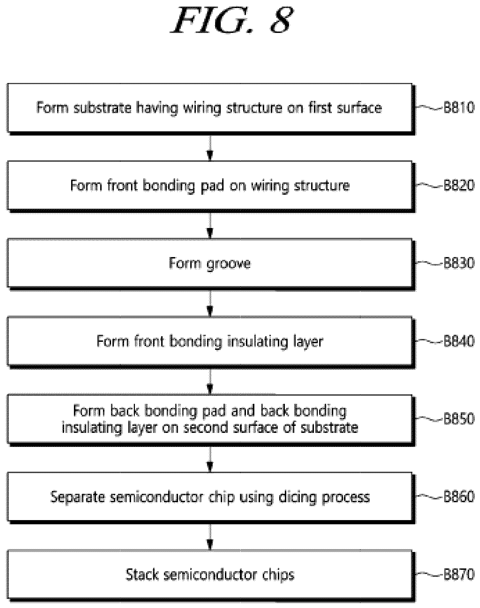

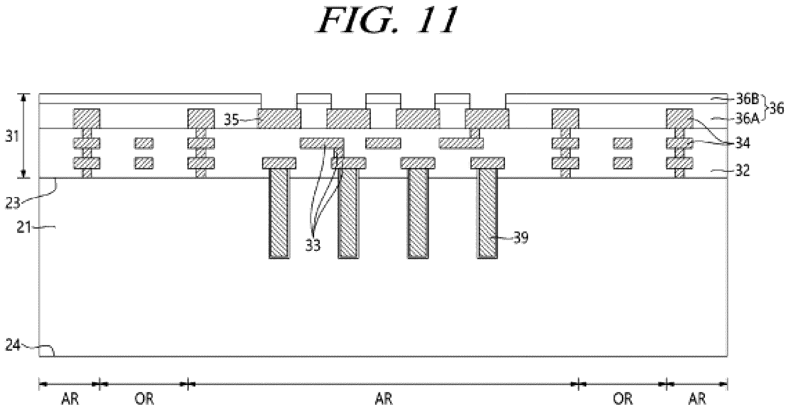

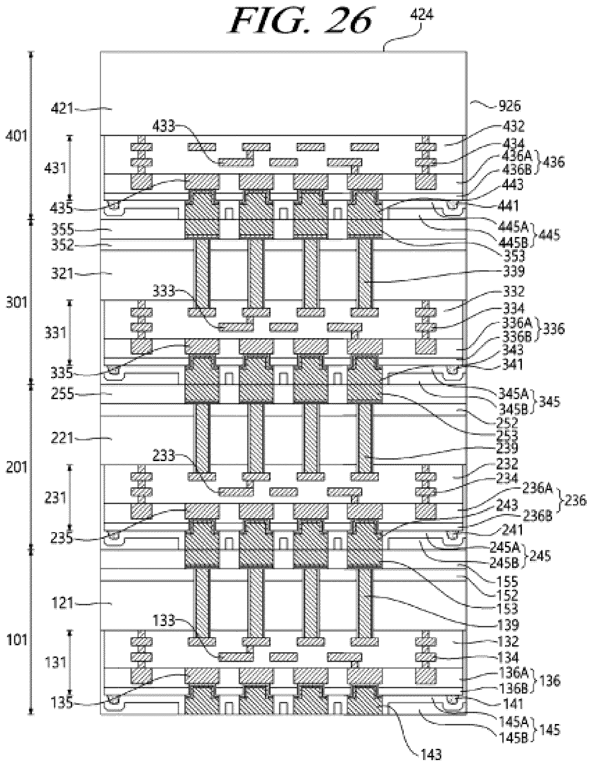

FIG. 8 is a flowchart illustrating a method of forming a semiconductor package according to an embodiment of the present disclosure. FIG. 9 is a plan view of a substrate 21 including a plurality of semiconductor chips 100, and FIG. 10 is a partial view illustrating section 11 of FIG. 9. FIG. 11 to FIG. 25 are cross-sectional views of a semiconductor package taken along line II' of FIG. 10 throughout a method of forming a semiconductor package according to an embodiment of the present disclosure. FIG. 26 is a cross-sectional view of a semiconductor package according to an embodiment of the present disclosure.

Referring to FIG. 8, the method of forming a semiconductor package according to an embodiment of the present disclosure includes forming a substrate including a wiring structure on a first surface B810, forming a front bonding pad on the wiring structure B810, forming a groove B830, forming a front bonding insulating layer B840, forming a back bonding pad and a back bonding insulating layer on a second surface of the substrate B850, separating the semiconductor chips using a dicing process B860, and stacking the semiconductor chips B870.

Referring to FIG. 9 and FIG. 10, a plurality of active areas AR are arranged in row and column directions within the substrate 21. An outer area OR is located or formed between consecutive active areas of the plurality of active areas AR. A guard ring 34 is formed within the active area AR as shown in the example of FIG. 10. The guard ring 34 may be covered, disposed, buried, or embedded adjacent to, at, or near a boundary between the active area AR and the outer area OR. In an embodiment, the guard ring 34 is an indicator utilized to distinguish the active area AR from the outer area OR. The guard ring outlines the boundary between the active area AR and the outer area OR. The border between the active area AR and the outer area OR is outlined by the guard ring 34. The active area AR is bordered by the guard ring 34. The outer area OR is the area between consecutive guard rings 34, for example, the guard ring 34 of an active area AR and the guard ring 34 of the nearest or neighboring active area AR. The guard ring 34 may be formed along the edge of the active area AR. In the plan view, the guard ring 34 may completely surround the active area AR. The outer area OR includes a scribe lane used to cut or separate the semiconductor chips 100 from the substrate 21.

In an embodiment, for example, as shown in FIG. 1 to FIG. 7, the guard ring 34 may include a plurality of patterns at the same level as the horizontal/vertical wiring 33 and the chip pad 35. The guard ring 34 may completely penetrate the circuit insulating layer 32. A first or lower end of the guard ring 34 may contact the substrate 21. A second or top end of the guard ring 34 may extend into the protective insulating layer 36. An upper surface of the guard ring 34 is formed in substantially the same plane as an upper or outer surface of the chip pad 35. The guard ring 34 may include the same material as the horizontal/vertical wiring 33 and the chip pad 35.

Referring to FIG. 8 and FIG. 11, a substrate 21 is formed including a wiring structure 31 on a first surface 23 B810. The wiring structure 31 includes a circuit insulating layer 32, a horizontal/vertical wiring 33, a guard ring 34, a chip pad 35, and a protective insulating layer 36. A through electrode 39 penetrates the substrate 21 in the vertical direction and is in contact with the horizontal/vertical wiring 33. As shown in the example of FIG. 2, a spacer 38 is included along the side surface of the through electrode 39.

The substrate 21 may include a semiconductor substrate such as a silicon wafer or a silicon-on-insulator (SOI) wafer. The substrate 21 may include a group III-V semiconductor substrate, for example, a compound semiconductor substrate such as gallium arsenide (GaAs). The substrate 21 may include single crystal silicon, polysilicon, amorphous silicon, single crystal silicon germanium, polycrystalline silicon germanium, carbon doped silicon, or a combination thereof.

The circuit insulating layer 32 may cover the active area AR and the outer area OR of the substrate 21. The horizontal/vertical wiring 33 and the guard ring 34 are included within the circuit insulating layer 32. The horizontal/vertical wiring 33 and the guard ring 34 are disposed in the active area AR. The guard ring 34 is disposed adjacent to or near the boundary of the active area AR and the outer area OR. In an embodiment, the wiring structure 31 further includes other components such as an align key, a vernier key, a dummy pattern, a test pattern, and so forth within the outer area OR.

The chip pad 35 is disposed in the active area AR within the circuit insulating layer 32. The chip pad 35 is connected to the horizontal/vertical wiring 33. The protective insulating layer 36 covers the circuit insulating layer 32 and covers a surface of the chip pad 35. Forming the protective insulating layer 36 may include a thin film forming process and a patterning process. While performing a patterning process to form an opening exposing the center area of the chip pad 35, an upper surface of the chip pad 35 is etched and partially recessed, as shown in the example of FIG. 2.

The through electrode 39 is disposed in the active area AR. The through electrode 39 is illustrated as formed by the via-middle process, but the through electrode 39 may also be formed by the via-first process or the via-last process.

The circuit insulating layer 32 includes a single layer or two or more layers of material. The circuit insulating layer 32 may include at least two materials selected from the group consisting of silicon (Si), oxygen (O), nitrogen (N), carbon (C), and boron (B). The circuit insulating layer 32 may include silicon oxide, silicon nitride, silicon oxynitride, silicon carbonitride (SiCN), silicon oxycarbonitride (SiOCN), a low-k dielectric, a high-k dielectric, or a combination thereof.

In an embodiment, the protective insulating layer 36 includes a lower protective insulating layer 36A and an upper protective insulating layer 36B. The upper protective insulating layer 36B is formed on the lower protective insulating layer 36A in this example.

Each of the horizontal/vertical wiring 33, the guard ring 34, the chip pad 35, and the through electrode 39 includes a single layer or two or more layers of material. Each of the horizontal/vertical wiring 33, the guard ring 34, the chip pad 35, and the through electrode 39 may include metal, metal silicide, metal nitride, metal oxide, polysilicon, conductive carbon, or a combination thereof. Each of the horizontal/vertical wiring 33, the guard ring 34, the chip pad 35, and the through electrode 39 may include tungsten (W), tungsten nitride (WN), titanium (Ti), titanium nitride (TiN), tantalum (Ta), tantalum nitride (TaN), cobalt (Co), nickel (Ni), silver (Ag), platinum (Pt), ruthenium (Ru), gold (Au), aluminum (Al), copper (Cu), tin (Sn), or a combination thereof. In an embodiment, the chip pad 35 may include aluminum (Al).

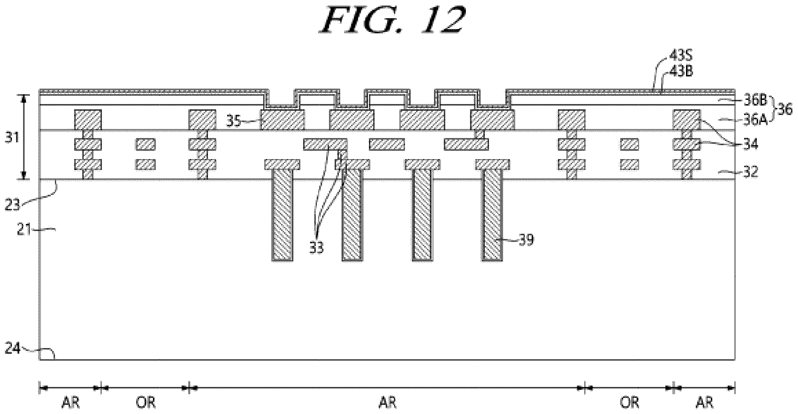

Referring to FIG. 12, a first barrier layer 43B and a first seed layer 43S are sequentially stacked on the wiring structure 31. The first barrier layer 43B directly contacts the chip pad 35 in the example of FIG. 12. The first barrier layer 43B may include titanium (Ti), titanium tungsten (TiW), titanium nitride (TiN), tantalum (Ta), tantalum nitride (TaN), or a combination thereof. The first seed layer 43S may include copper.

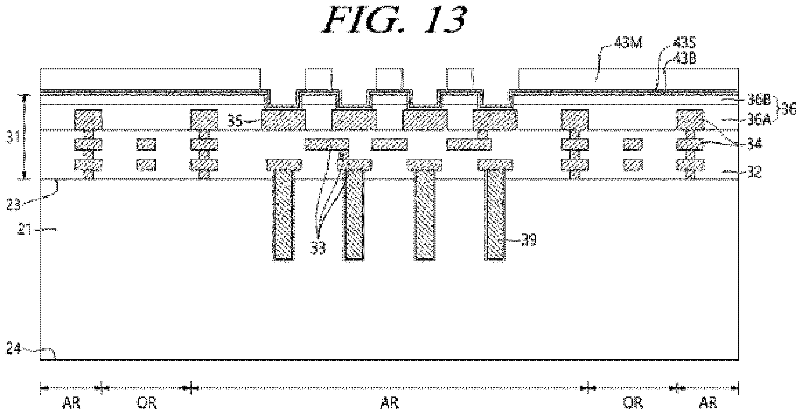

Referring to FIG. 13, a mask pattern 43M is formed on a section of the first seed layer 43S. The mask pattern 43M may include a photoresist pattern.

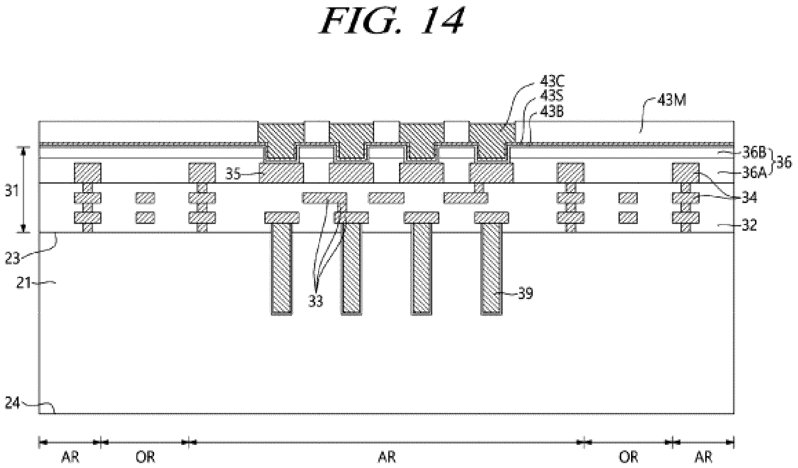

Referring to FIG. 14, a first conductive layer 43C is formed on the first seed layer 43S. The first conductive layer 43C may include metal, metal nitride, or a combination thereof. The first conductive layer 43C may include copper (Cu), tungsten (W), tungsten nitride (WN), titanium (Ti), tungsten titanium (TiW), titanium nitride (TiN), tantalum (Ta), tantalum nitride (TaN), cobalt (Co), nickel (Ni), silver (Ag), platinum (Pt), ruthenium (Ru), gold (Au), aluminum (Al), tin (Sn), or a combination thereof. In an embodiment, the first conductive layer 43C includes a copper layer formed using an electrolytic plating method.

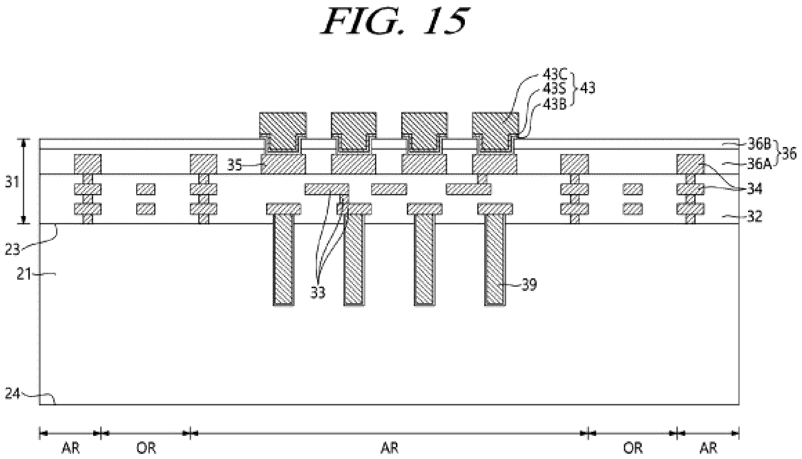

Referring to FIG. 8 and FIG. 15, the front bonding pad 43 is formed by removing the mask pattern 43M and partially removing the first barrier layer 43B and the first seed layer 43S B820. For example, the first barrier layer 43B and the first seed layer 43 may be removed with the mask pattern 43M and may be removed from the same area on the upper protective insulating layer 36B as the mask pattern 43M. The front bonding pad 43 includes a first barrier layer 43B, a first seed layer 43S, and a first conductive layer 43C, which are sequentially stacked as shown, for example, in FIG. 2. The front bonding pad 43 contacts the chip pad 35. The front bonding pad 43 is disposed in the active area AR.

Referring to FIG. 8 and FIG. 16, a groove 31G penetrates the wiring structure 31 within the outer area OR B830. The groove 31G is formed along or centered on the center line of the outer area OR. The groove 31G has a narrower horizontal width than the width of the outer area OR. When forming the groove 31G, segments of the wiring structure 31 within the outer area OR may be removed. In an embodiment, a laser grooving process is used to form the groove 31G.

In an embodiment, the process of forming the groove 31G B830 is performed after the performing the process of forming the front bonding pad 43 B820. During the process of forming the groove 31G, structures such as test patterns, alignment keys, and so forth within the outer area OR may be damaged, and a protrusion pattern 41 is created or formed on the protective insulating layer 36 from separated segments of the structures as a result of the process of forming the groove 31G. The protrusion pattern 41 may be disposed on or attach to the protective insulating layer 36 near or adjacent to the groove 31G. In an embodiment, the protrusion pattern 41 is formed on the protective insulating layer 36 within the outer area OR. The bottom of the protrusion pattern 41 is formed at a lower level than the top of the front bonding pad 43. The bottom of the protrusion pattern 41 is formed at a level higher than the top of the chip pad 35. The protrusion pattern 41 may have an irregular or uneven shape and may extend along the length of both sides of the groove 31G.

The protrusion pattern 41 may include metal, metal silicide, metal nitride, metal oxide, polysilicon, conductive carbon, an inorganic material, or a combination thereof. In an embodiment, the protrusion pattern 41 includes a metal such as copper, aluminum, tungsten, or titanium. The protrusion pattern 41 may include metal burrs. The protrusion pattern 41 includes the same material as the structure, such as the test pattern, the alignment key, and so forth, within the outer area OR in this example.

The bottom of the groove 31G is formed at a horizontal level adjacent to the boundary of the substrate 21 and the wiring structure 31 as shown in FIG. 16. The groove 31G may be formed at different depths, such as shown in FIG. 2 to FIG. 6. The bottom of the groove 31G may be formed at substantially the same horizontal level as the boundary between the substrate 21 and the circuit insulating layer 32, such as shown in FIG. 2. The bottom of the groove 31G2 may be formed at a level below the bottom surface of the circuit insulating layer 32, such as shown in FIG. 3, where the groove 31G2 completely penetrates the wiring structure 31 and extends into the substrate 21. The bottom of the groove 31G3 may be formed at a level higher than the bottom surface of the circuit insulating layer 32, such as shown in FIG. 4.

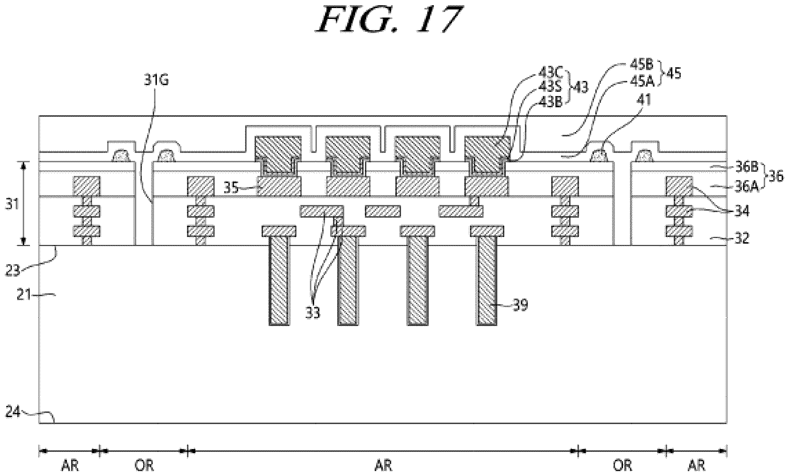

Referring to FIG. 17, the front bonding insulating layer 45 covering the front bonding pad 43 and the protrusion pattern 41 is formed B840 on the wiring structure 31. The protrusion pattern 41 may be covered, disposed, or buried within the front bonding insulating layer 45. The front bonding insulating layer 45 may fill the entire groove 31G.

In an embodiment, the front bonding insulating layer 45 includes a lower bonding insulating layer 45A and an upper bonding insulating layer 45B. The upper bonding insulating layer 45B is formed on the lower bonding insulating layer 45A. The lower bonding insulating layer 45A covers the upper surfaces and the side surfaces of the front bonding pads 43 and the protrusion pattern 41. The lower bonding insulating layer 45A extends inside the groove 31G. The lower bonding insulating layer 45A contacts the sides of the wiring structure 31.

In an embodiment, the protrusion pattern 41 is formed before performing the process of forming the front bonding insulating layer 45. The protrusion pattern 41 includes a material different that the material of the front bonding insulating layer 45.

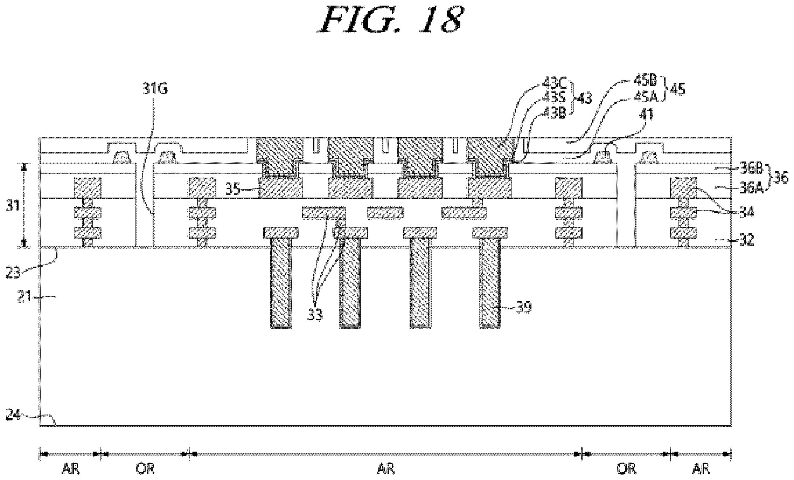

Referring to FIG. 8 and FIG. 18, the process of forming the front bonding insulating layer 45 B840 includes a process of partially removing the front bonding insulating layer 45 using a planarization process to expose an upper surface of the front bonding pad 43. The upper surfaces of the front bonding insulating layer 45 and the front bonding pad 43 are formed in substantially the same plane. The planarization process including partially removing the front bonding insulating layer 45 to expose the upper surface of the front bonding pad 43 may include a chemical mechanical polishing (CMP) process, an etch-back process, or a combination thereof.

In an embodiment, the lower bonding insulating layer 45A covers the protrusion pattern 41 and surrounds the sides of the front bonding pad 43. The lower bonding insulating layer 45A may extend between the front bonding pad 43 and the upper bonding insulating layer 45B. The uppermost surfaces of the front bonding pad 43, the lower bonding insulating layer 45A, and the upper bonding insulating layer 45B are formed in substantially the same plane.

In an embodiment, the process of forming the front bonding pad 43 B820, the process of forming the groove 31G B830, and the process of forming the front bonding insulating layer 45 B840 are performed sequentially. For example, after performing the process of forming the front bonding pad 43 B820 is performed, the process of forming the groove 31G is performedB830. After performing the process of forming the groove 31G B830, the process of forming the front bonding insulating layer 45 (B840) is performed.

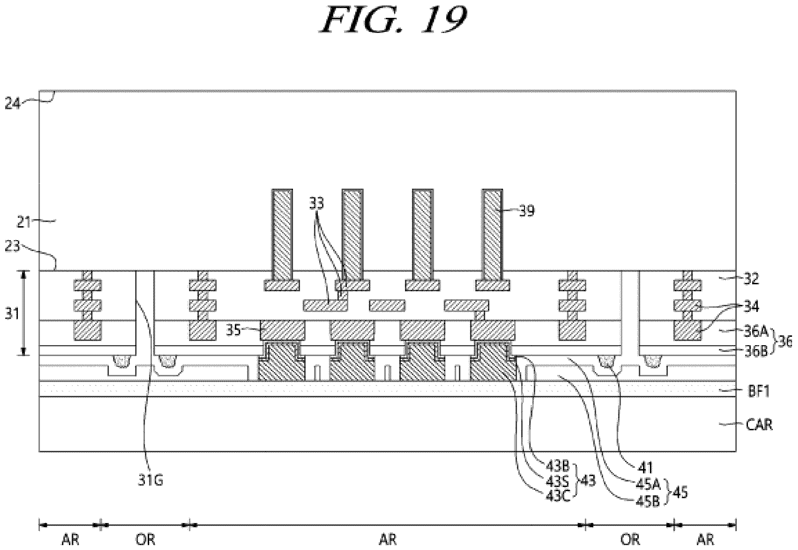

Referring to FIG. 19, the substrate 21 including the front bonding insulating layer 45 and the front bonding pad 43 is disposed or loaded on a carrier CAR. A first buffer layer BF1 is formed between the carrier CAR and the front bonding insulating layer 45 and between the carrier CAR and the front bonding pad 43. The second surface 24 of the substrate 21 is exposed.

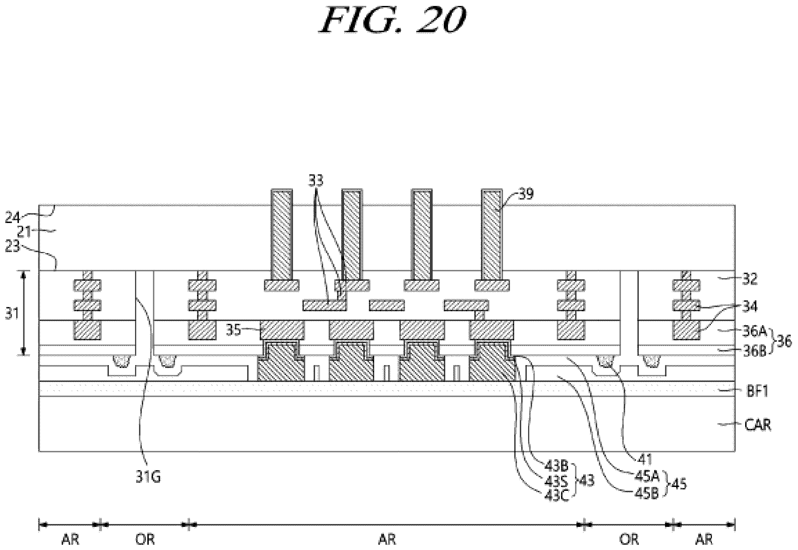

Referring to FIG. 20, the substrate 21 is partially removed to expose the through electrodes 39. The second surface 24 of the substrate 21 is recessed to level lower than the top of the through electrode 39.

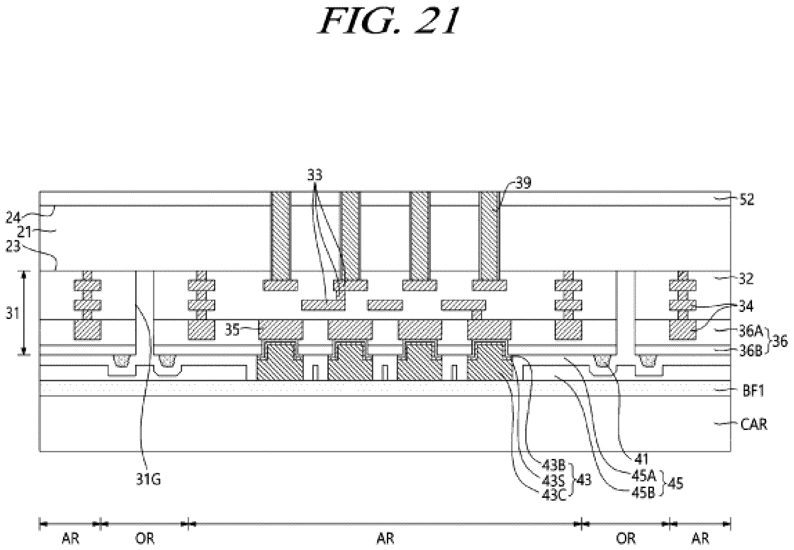

Referring to FIG. 21, the back insulating layer 52 is formed on the second surface 24 of the substrate 21. As the back insulating layer 52 is formed, the upper surface of the through electrode 39 is exposed. In an embodiment, the upper surface of the back insulating layer 52 and the upper surface of the through electrode 39 are exposed in substantially the same plane.

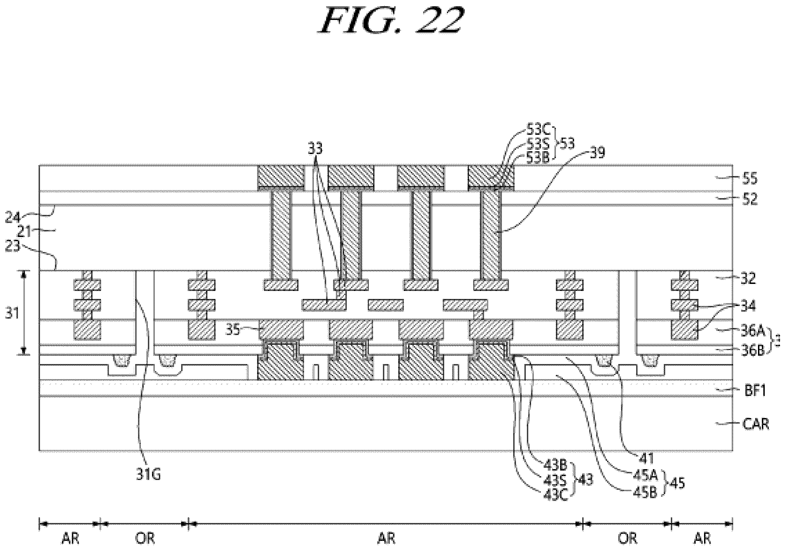

Referring to FIG. 8 and FIG. 22, a back bonding pad 53 and a back bonding insulating layer 55 are formed on the second surface 24 of the substrate 21 B850. The back bonding insulating layer 55 covers the back insulating layer 52. The back bonding pad 53 is disposed within the back bonding insulating layer 55. Each back bonding pad 53 is aligned or centered on the through electrode 39 and disposed in the active area AR. The back bonding pad 53 contacts the through electrode 39. The upper surface of the back bonding pad 53 and the upper surface of the back bonding insulating layer 55 are exposed in substantially the same plane.

The back bonding pad 53 may include metal, metal nitride, or a combination thereof. In an embodiment, the back bonding pad 53 include a second barrier layer 53B, a second seed layer 53S, and a second conductive layer 53C that are sequentially stacked. The second barrier layer 53B contacts the through electrode 39. The second barrier layer 53B may include titanium (Ti), titanium tungsten (TiW), titanium nitride (TiN), tantalum (Ta), tantalum nitride (TaN), or a combination thereof. The second seed layer 53S may include copper. The second conductive layer 53C may include copper (Cu), tungsten (W), tungsten nitride (WN), titanium (Ti), tungsten titanium (TiW), titanium nitride (TiN), tantalum (Ta), tantalum nitride (TaN), cobalt (Co), nickel (Ni), silver (Ag), platinum (Pt), ruthenium (Ru), gold (Au), aluminum (Al), tin (Sn), or a combination thereof. In an embodiment, the second conductive layer 53C includes the same material as the first conductive layer 43C. The second conductive layer 53C may include a copper layer formed using an electrolytic plating method.

Each of the back insulating layer 52 and the back bonding insulating layer 55 includes a single layer or two or more layers of material. Each of the back insulating layer 52 and the back bonding insulating layer 55 may include at least two materials selected from the group consisting of silicon (Si), oxygen (O), nitrogen (N), carbon (C), and boron (B). Each of the back insulating layer 52 and the back bonding insulating layer 55 may include silicon oxide, silicon nitride, silicon oxynitride, silicon carbonitride (SiCN), silicon oxycarbonitride (SiOCN), a low-K dielectric material, a high-K dielectric material, or a combination thereof. In an embodiment, the back bonding insulating layer 55 may include the same material as the front bonding insulating layer 45. The back bonding insulating layer 55 may include silicon oxide or silicon carbonitride (SiCN).

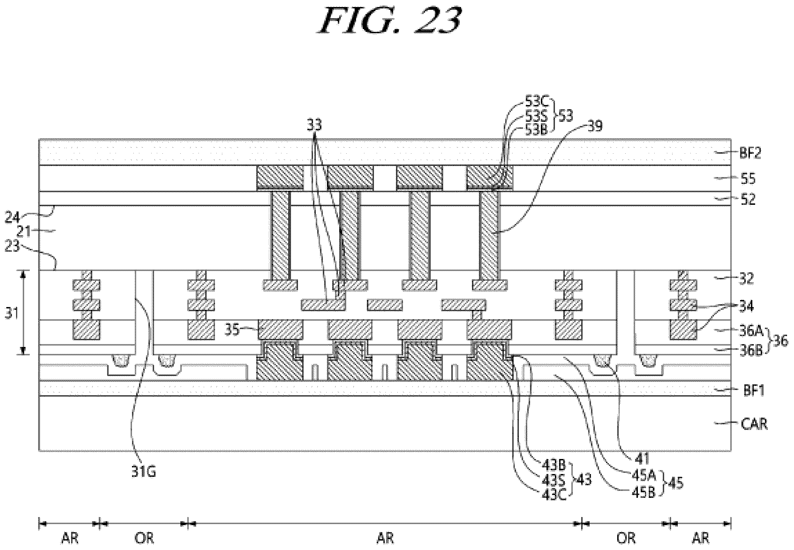

Referring to FIG. 23, a second buffer layer BF2 is formed on the back bonding pad 53 and the back bonding insulating layer 55. The second buffer layer BF2 may include a layer of elastic material such as lamination tape.

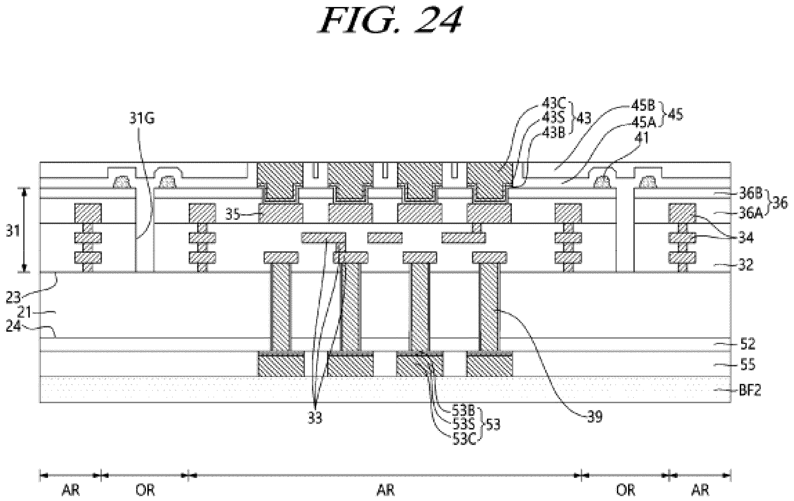

Referring to FIG. 24, the front bonding insulating layer 45 and the front bonding pad 43 are exposed by removing the carrier CAR and the first buffer layer BF1.

Referring to FIG. 8 and FIG. 25, the semiconductor chips 100 are separated using a dicing process B860. The second buffer layer BF2 is optionally removed. The dicing process may include a laser stealth dicing process, a laser dicing process, a plasma dicing process, a blade sawing process, or a combination thereof. In an embodiment, the dicing process includes the laser stealth dicing process. While the dicing process is performed, the front bonding insulating layer 45, the substrate 21, the back insulating layer 52, and the back bonding insulating layer 55 are be cut in the vertical direction.

The area cut by the dicing process is located along the center line of the outer area OR shown in FIG. 10. The area cut by the dicing process has a horizontal width narrower than the width of the outer area OR. The area cut by the dicing process is located vertically above the groove 31G. In an embodiment, the area cut by the dicing process has a horizontal width narrower than the width of the groove 31G, and the front bonding insulating layer 45 within the groove 31G partially remains after the dicing process.

In an embodiment, the area cut by the dicing process has a horizontal width larger than the groove 31G. As shown in FIG. 5, side surfaces of the substrate 21, the circuit insulating layer 32, the protective insulating layer 36, and the front bonding insulating layer 45 are exposed. The side surfaces of the substrate 21, the circuit insulating layer 32, the protective insulating layer 36, and the front bonding insulating layer 45 are formed in substantially the same plane.

According to the present disclosure, part or all of the wiring structure 31 disposed in the outer area OR is removed by forming the groove 31G as described with reference to FIG. 16. The wiring structure 31 in the outer area OR includes a plurality of structures, such as test patterns, alignment keys, vernier keys, dummy patterns, and so forth, which structures are made of various materials. The wiring structure 31 includes a material(s) different than the materials of the substrate 21 and the front bonding insulating layer 45. In an embodiment, the wiring structure 31 in the outer area OR may include a metal, and the substrate 21, the circuit insulating layer 32, the protective insulating layer 36, and the front bonding insulating layer 45 may include non-metallic inorganic materials. Non-metallic inorganic materials are brittle materials that may crack and are easily cut as the stress generated during the dicing process propagates. Because metal is a ductile material, plastic deformation may occur even when stress is applied, which may prevent separation or leave residue during the dicing process. Because the wiring structure 31 in the area to be cut is removed while forming the groove 31G in advance of the dicing process, defects in which the semiconductor chips 100 are not separated during the dicing process due to plastic deformation of the wiring structure 31 may be prevented.

Referring to FIG. 8 and FIG. 26, the second to fourth semiconductor chips 201, 301 and 401 are sequentially stacked on the first or lowermost semiconductor chip 101 B870. Each of the semiconductor chips 101, 201, 301, and 401 may include the same configuration, such as described with reference to FIG. 1 to FIG. 25.

In an embodiment, the second semiconductor chip 201 is bonded to the first semiconductor chip 101. The first semiconductor chip 101 is aligned with the second semiconductor chip 201. The second front bonding insulating layer 245 of the second semiconductor chip 201 contacts the first back bonding insulating layer 155 of the first semiconductor chip 101. The first back bonding insulating layer 155 is aligned with the second front bonding insulating layer 245. The second front bonding pad 243 of the second semiconductor chip 201 contacts the first back bonding pad 153 of the first semiconductor chip 101. The first back bonding pad 153 is aligned with the second front bonding pad 243. The first through electrode 139, the first back bonding pad 153, and the second front bonding pad 243 are aligned in the vertical direction. In an embodiment, the first back bonding pad 153 is aligned with the first through electrode 139, and the second front bonding pad 243 is aligned with the first back bonding pad 153.

The third semiconductor chip 301 is bonded to the second semiconductor chip 201. The second semiconductor chip 201 is aligned with the third semiconductor chip 301. The third front bonding insulating layer 345 of the third semiconductor chip 301 contacts the second back bonding insulating layer 255 of the second semiconductor chip 201. The third front bonding pad 343 of the third semiconductor chip 301 contacts the second back bonding pad 253 of the second semiconductor chip 201. The second through electrode 239, the second back bonding pad 253, and the third front bonding pad 343 are aligned in the vertical direction.

The fourth semiconductor chip 401 is bonded to the third semiconductor chip 301. The third semiconductor chip 301 is aligned with the fourth semiconductor chip 401. The fourth front bonding insulating layer 445 of the fourth semiconductor chip 401 contacts the third back bonding insulating layer 355 of the third semiconductor chip 301. The fourth front bonding pad 443 of the fourth semiconductor chip 401 contacts the third back bonding pad 353 of the third semiconductor chip 301. The third through electrode 339, the third back bonding pad 353, and the fourth front bonding pad 443 are aligned in the vertical direction. One or more other semiconductor chips may be additionally bonded between the third semiconductor chip 301 and the uppermost semiconductor chip, the fourth semiconductor chip 401 in this example.

Referring to FIG. 7, the method of forming a semiconductor package according to the present disclosure may include sequentially bonding the semiconductor chips 101, 201, 301 and 401 on the base structure 921.

The first semiconductor chip 101 is mounted on the base structure 921. A connection terminals 923 are formed between the first front bonding pads 143 of the first semiconductor chip 101 and the base structure 921. The semiconductor chips 201, 301, and 401 are bonded to the first semiconductor chip 101 in a similar manner as described with reference to FIG. 26.

Concepts are disclosed in conjunction with examples and embodiments as described above. Those skilled in the art will understand that various modifications, additions, and substitutions are possible without departing from the scope and technical concepts of the present disclosure. The embodiments disclosed in the present specification should be considered from an illustrative standpoint and not a restrictive standpoint. Therefore, the scope of the present disclosure is not limited to the above descriptions. All changes within the meaning and range of equivalency of the claims are included within their scope.

## Claims

1. A semiconductor package comprising:
a substrate;
a through electrode within the substrate;
a wiring structure disposed on the substrate and including a chip pad and a protective insulating layer;
a protrusion pattern on the protective insulating layer;
a front bonding insulating layer on the wiring structure, the protrusion pattern disposed within the front bonding insulating layer; and
a front bonding pad disposed within the front bonding insulating layer and connected to the chip pad.

2. The semiconductor package of claim 1, wherein the front bonding insulating layer includes a first surface in contact with the wiring structure and a second surface opposing the first surface,
wherein the protrusion pattern is disposed between the wiring structure and the second surface.

3. The semiconductor package of claim 2, wherein one surface of the front bonding pad is disposed in substantially the same plane as the second surface of the front bonding insulating layer.

4. The semiconductor package of claim 1, wherein a distance between an edge of the wiring structure and the protrusion pattern is smaller than a distance between the edge of the wiring structure and the chip pad.

5. The semiconductor package of claim 1, wherein the wiring structure further includes a guard ring outlining a boundary between an active area and an outer area, wherein the protrusion pattern is disposed within the outer area.

6. The semiconductor package of claim 1, wherein the front bonding insulating layer includes:
a first bonding insulating layer on the protective insulating layer and the protrusion pattern; and
a second bonding insulating layer on the first bonding insulating layer;
wherein the first bonding insulating layer covers a second surface and a side surface of the protrusion pattern;
wherein the first bonding insulating layer extends between the front bonding pad and the second bonding insulating layer.

7. The semiconductor package of claim 6, wherein a surface of the front bonding pad, a surface of the first bonding insulating layer, and a surface of the second bonding insulating layer are formed in substantially the same plane.

8. The semiconductor package of claim 1, wherein a width of the front bonding insulating layer is substantially the same as a width of the substrate.

9. The semiconductor package of claim 1, wherein a width of the wiring structure is smaller than a width of the substrate,
wherein the front bonding insulating layer extends along a side surface of the wiring structure.

10. The semiconductor package of claim 1, wherein one end of the front bonding insulating layer contacts the substrate.

11. The semiconductor package of claim 1, wherein side surfaces of the substrate and the front bonding insulating layer are formed in substantially the same plane.

12. The semiconductor package of claim 1, wherein the protrusion pattern includes a different material than a material of the front bonding insulating layer.

13. The semiconductor package of claim 1, wherein the substrate includes a first surface opposing a second surface, and the wiring structure is disposed on the first surface,
wherein the semiconductor package further comprises:
a back insulating layer on the second surface of the substrate;
a back bonding insulating layer disposed on the back insulating layer; and
a back bonding pad disposed within the back bonding insulating layer and connected to the through electrode.

14. The semiconductor package of claim 13, wherein side surfaces of the back bonding insulating layer, the substrate, and the front bonding insulating layer are formed in substantially the same plane.

15. The semiconductor package of claim 1, wherein the protective insulating layer is disposed on an edge of the chip pad,
wherein the front bonding pad penetrates the protective insulating layer and contacts the chip pad,
wherein a thickness of the chip pad in a contact area between the chip pad and the front bonding pad is smaller than a thickness of the chip pad at an outermost perimeter of the chip pad.

16. A semiconductor package comprising:
a first semiconductor chip; and
a second semiconductor chip bonded to the first semiconductor chip,
wherein the first semiconductor chip comprises:
a first substrate;
a first through electrode in the first substrate;
a first wiring structure disposed on the first substrate and including a first chip pad and a first protective insulating layer;
a first protrusion pattern on the first protective insulating layer;
a first front bonding insulating layer on the first wiring structure, the first protrusion pattern disposed within the first front bonding insulating layer; and
a first front bonding pad disposed within the first front bonding insulating layer and connected to the first chip pad;
wherein the second semiconductor chip comprises:
a second substrate;
a second wiring structure disposed on the second substrate and including a second chip pad and a second protective insulating layer;
a second protrusion pattern on the second protective insulating layer;
a second front bonding insulating layer on the second wiring structure, the second protrusion pattern disposed within the second front bonding insulating layer; and
a second front bonding pad disposed within the second front bonding insulating layer and connected to the second chip pad.

17. The semiconductor package of claim 16, wherein the first substrate includes a first surface opposing a second surface, and the first wiring structure is disposed on the first surface,
wherein the first semiconductor chip further comprises:
a first back insulating layer on the second surface;
a first back bonding insulating layer disposed on the first back insulating layer; and
a first back bonding pad disposed within the first back bonding insulating layer and connected to the first through electrode,
wherein the second front bonding insulating layer is bonded to the first back bonding insulating layer,
wherein the second front bonding pad is bonded to the first back bonding pad.

18. The semiconductor package of claim 17, wherein the first back bonding pad is aligned with the first through electrode,
wherein the second front bonding pad is aligned with the first back bonding pad.

19. The semiconductor package of claim 17, wherein the first back bonding insulating layer is aligned with the second front bonding insulating layer.

20. A semiconductor package comprising:
a substrate;
a wiring structure disposed on the substrate and including a chip pad and a protective insulating layer;
a protrusion pattern on the protective insulating layer;
a front bonding insulating layer on the wiring structure, the protrusion pattern disposed within the front bonding insulating layer; and
a front bonding pad disposed within the front bonding insulating layer and connected to the chip pad.
